(19) Europäisches Patentamt / European Patent Office / Office européen des brevets

(11) **EP 2 325 152 A1**

(12) # EUROPEAN PATENT APPLICATION
published in accordance with Art. 153(4) EPC

(43) Date of publication:
**25.05.2011 Bulletin 2011/21**

(21) Application number: **09802536.4**

(22) Date of filing: **23.07.2009**

(51) Int Cl.:
**C04B 41/50** (2006.01)   **C04B 41/51** (2006.01)
**C23C 16/40** (2006.01)

(86) International application number:
**PCT/ES2009/000393**

(87) International publication number:
**WO 2010/012849 (04.02.2010 Gazette 2010/05)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **01.08.2008 ES 200802316**

(71) Applicant: **COSENTINO, S.A.**
**04850 Cantoria Almeria (ES)**

(72) Inventors:
• **RAMON MORENO, Jose, Luis**
 **04850 Cantoria**
 **Almeria (ES)**
• **RODRIGUEZ GARCIA, Salvador, Cristobal**
 **04850 Cantoria**
 **Almeria (ES)**
• **POZAS BRAVO, Raul**
 **04850 Cantoria**
 **Almeria (ES)**

• **GRACIA TORRES, Francisco**
 **04850 Cantoria**
 **Almeria (ES)**
• **MEDINA JIMENEZ, Adrian**
 **04850 Cantoria**
 **Almeria (ES)**
• **YUBERO VALENCIA, Francisco**
 **E - 04850 Cantoria - Almeria (ES)**
• **RODRIGUEZ GONZÁLEZ-ELIPE, Augustín**
 **E - 04850 Cantoria - Almeria (ES)**
• **ROMERO GÓMEZ, Pablo**
 **E - 04850 Cantoria - Almeria (ES)**
• **DEL ARCO GONZÁLEZ, Patricia**
 **E - 04850 Cantoria - Almeria (ES)**
• **GIL ROSTRA, Jorge**
 **E - 04850 Cantoria - Almeria (ES)**

(74) Representative: **Gonzalez-Alberto Rodriguez, Natalia**
 **Garrigues**
 **Hermosilla, 3**
 **28001 Madrid (ES)**

(54) **STONE AGGLOMERATE SLAB OR FLAG WITH TIO2 OR ZNO COATING**

(57) Item in slab form made form stone agglomerate coated with thin transparent films of TiO2 or ZnO by means of dry deposition techniques with high resistance to solar degradation, said article having the form of a slab or flag fabricated from stone agglomerate coated with a thin, transparent film of TiO2 and/or ZnO with low or zero photocatalytic activity, said film being deposited by means of dry deposition, physical vapour deposition (PVD) or plasma enhanced chemical vapour deposition (PECVD) techniques. Said article has a high level of resistance to solar degradation, which means that the resulting material is suitable for external environments.

EP 2 325 152 A1

**Description**

Technical Field of the Invention

The present invention relates to an item in slab form made from stone agglomerate, coated with a thin transparent film of $TiO_2$ and/or ZnO with low or nil photocatalytic activity, deposited by dry deposition techniques, such as physical vapor deposition or PVD or plasma-enhanced chemical vapor deposition or PECVD. This item has a high resistance to solar degradation, which makes the material obtained suitable for outdoor environments.

Background of the Invention

The items using unsaturated orthophthalic polyester resins generally do not have suitable resistance to solar radiation. This becomes evident as a result of the yellowing of the part exposed directly to the sun due to decompositions of radicals in said resin activated by UV radiation. Thus, for the use of these materials in outdoor environments exposed to solar radiation, it is necessary to improve this property.

A solution to the problem would be the use of another resin as a binder with a higher resistance to solar radiation, as is described in patent document WO 2006/100321 A1, belonging to the same inventors as the present application, although in several of the embodiments which are described, other aesthetic and mechanical properties would be sacrificed.

Another solution to the problem, which is the object of the present invention, consists of the surface deposition of materials absorbing UV radiation, thus increasing the resistance to degradation of the material exposed to sunlight. Among these materials, thin films of titanium (IV) oxide ($TiO_2$) or zinc (II) oxide (ZnO) also present optical transparency properties at wavelengths comprised in the visible spectrum, which is vital for maintaining the original decorative aspect of the substrate.

Patent application WO 97/10185 A1 describes substrates provided with a coating with photocatalytic properties based on titanium dioxide, incorporated to said coating in the form of particles, mostly crystallized under the crystalline anatase form, as well as the method of preparing said substrates.

The substrate obtained is used for the manufacture of self-cleaning, anti-fogging and/or anti-dirt glazing, especially glazing for constructing double-type glazing, glazing for vehicles such as windshields or windows for automobiles, trains, planes, display windows, television displays or aquariums.

Specifically, the process of obtaining this substrate, consists of depositing the coating by liquid phase pyrolysis or by the technique referred to as sol-gel from a suspension, comprising at least one organometallic compound and a dispersion of titanium dioxide particles. The titanium dioxide particles will preferably be incorporated to the coating by means of a binder. In a first embodiment, the binder which incorporates the particles to the coating can be a mineral binder. It can particularly be presented in the form of an amorphous or partially crystallized oxide (or mixture of oxides), for example silicon, titanium, tin, zirconium or aluminium oxide.

In a second embodiment, the binder can also be at least partly organic, particularly in the form of a polymeric matrix. It can be a polymer which has properties that are complementary to those of the titanium dioxide particles and particularly hydrophobic and/or oleophobic properties.

The substrate on which the coating is applied can be of various natures, ranging from any type of construction material (metals, concretes) to substrates of a glass-ceramic base.

Patent application WO 99/44954 A1 describes a method for obtaining a substrate which is provided with a photocatalytic coating. Particles of an oxide of metal A with photocatalytic properties are incorporated in said coating by means of the aid of a mineral binder. The binder includes at least one oxide of metal B also having photocatalytic properties. The binder can also optionally include an oxide of metal M devoid of photocatalytic properties and/or at least one silicon compound, such as silicon oxide $SiO_2$.

The oxides of metals A and B are chosen from one of at least the following oxides: titanium oxide, zinc oxide, tin oxide and tungsten oxide. In a preferred embodiment the oxides of A and B are both chosen in the form of titanium oxide. The M-type oxides devoid of photocatalytic properties are, for example, aluminium or zirconium oxide. The titanium oxide is in its anatase form so that it has the desired photolytic properties.

For the deposition of these materials a first type of technique referred to as "hot" is used, i.e., during the contact of dispersion/substrate, the latter is at a high temperature to allow the thermal decomposition of the precursors (this is the liquid phase pyrolysis technique)

A second type of technique used is referred to as "cold" and during the contact of dispersion/substrate, the latter is at ambient temperature or at least at a very low temperature to cause the decomposition of the precursors: these are the sol-gel techniques with "immersion" or laminar coating deposition.

Patent document EP 1837319 A2 describes slabs or tiles made from stone agglomerate which have been coated with a thin film deposited by the PECVD technique under a vacuum, the chemical composition of which is

$Si_xO_yC_zH_w$, in which the parameters x and z w are modified according to the process used. The substrates on which the films are deposited can be calcium carbonate and resin agglomerates or they can also be applied in granite/quartz and polyester resin agglomerates.

This document particularly describes the process for obtaining the stone materials, comprising the polymerization on a stone agglomerate of a suitable monomer, preferably hexamethyldioxane, in plasma phase by irradiation with a frequency between 13 and 14 MHz, optionally in the presence of other gases, at a pressure between 50 Pa and 0.5 Pa, i.e., under a vacuum.

Patent application WO 2008/045226 A1 describes a process for coating or modifying a substrate comprising: a) providing a substrate having at least one surface; b) providing a gaseous mixture adjacent to at least one surface of (a); c) generating a plasma in the gaseous mixture of (b); and d) allowing the plasma of (c) to form a solid deposit on the at least one surface of the substrate; in which the gaseous mixture comprises: at least 35 volume-percent nitrogen gas; at least 50 ppm of a gaseous precursor which can comprise at least one silicon compound, such as a silane or siloxane, or a compound containing a metal such as Zn, Sn, A1 and Ti; and optionally an oxidative gas of the gaseous precursor. This PECVD process can be carried out at 20°C and 101 kPa, i.e., at atmospheric pressure and temperature.

In the state of the art, in the mentioned documents relating to PECVD deposition process and in those relating to coating substrates, also mentioned previously, the $TiO_2$ particles have been deposited from a stable dispersion thereof on the substrates in order to provide them with photocatalytic properties. For this application, the $TiO_2$ must present a photocatalytically active crystalline form. When the phase of the crystalline form is anatase, it is a semiconductor (band gap of 3.2 eV) with a high reactivity which can be activated by the UV radiation present in sunlight. After the excitation of the anatase phase with a photon having a wavelength of less than 385 nm, an electron hole is generated in the surface of the $TiO_2$, resulting in the production of OH • radicals and of intermediate species from the reduction of $O_2$ to $O^{2-}$, which are very reactive in contact with the organic matter. This causes decomposition reactions based on free radicals in the polymer present in the surface of the stone agglomerate, thus accelerating its yellowing.

Therefore, there is still a need to protect substrates, specifically stone or marble substrates, coated with polyester resins which are to be used in outdoor environments, particularly in sunny areas or countries.

The provided solution, object of the present invention, first requires that both the $TiO_2$ and the ZnO have very low or nil photocatalytic activity, maintaining their UV radiation absorption properties. To that end, these materials must be deposited as an amorphous or low crystallinity phase, or they can be doped with a low concentration of cations of transition elements (Cr, V, W, Fe, Co) or of post-transition elements (A1, Si). On the other hand, the control of the thickness and the microstructure of the resulting layer is essential for achieving the optimal properties of UV absorption as well as for preventing the light scattering which can generate off-white colors, thus assuring the transparency required for this application. Finally, a permanent adhesion of the coating to the stone agglomerate which provides properties of resistance to abrasion that are suitable for their application in outdoor spaces, is sought.

A very important aspect to be considered in the choice of the method of deposition of these materials is the heat-sensitive nature of the stone agglomerates, for which reason the entire method of deposition must be carried out by means of a technique which requires temperatures close to ambient temperature. To this respect, the wet deposition (sol-gel) of these materials without a subsequent heating step at temperatures > 300°C in which the substrate would be degraded does not provide the properties of adhesion, compaction and resistance to abrasion of the layer necessary for this application.

## Description of the Invention

The present invention consists of obtaining stone or marble agglomerates with an improved resistance to solar radiation through the deposition of thin transparent films of controlled thickness of $TiO_2$ or ZnO with low or nil photocatalytic activity on their surface, by means of dry deposition techniques (PECVD, PVD) under a vacuum or at atmospheric pressure. To minimize the photocatalytic activity these materials may have, they will be deposited as amorphous or low crystallinity phases and/or they will be doped with cations of transition elements (Cr, V, W, Fe, Co) or post-transition elements (Al, Si).

In addition to the high resistance to solar radiation, these compounds provide other properties to the stone or marble agglomerate that are very interesting for some specific applications in outdoor spaces, such as antistatic properties in paving or super-hydrophilic properties that are easy to clean in decorative elements installed in hard-to-access places.

The essential advantage of dry deposition is that it allows depositing these materials at a temperature close to the ambient temperature, which allows obtaining amorphous or low crystallinity phases and in turn eliminating the risk that the stone agglomerate has of thermally degrading. In addition, these techniques allow the controlled doping of these materials with cations of the aforementioned elements. They likewise allow obtaining very homogenous layers of controlled thickness, in turn assuring magnificent properties of adhesion thereof to the base agglomerate, as well as properties of resistance to abrasion for their application as decorative elements in outdoor spaces (façades, buildings...).

For the case of this invention, the coating would be applied on a slab made from stone or marble agglomerate manufactured according to the traditional process and with the desired surface finish to prevent other mechanical treatments from being able to damage the coating.

Brief Description of the Drawings

Figure 1 shows a variation of the total reflectance values measured at 450 nm in the pieces of uncoated quartz agglomerate and quartz agglomerate coated with thin transparent films of $TiO_2$ of different thicknesses according to the time of exposure to solar radiation.
Figure 2 shows a variation of the parameter b* (db*), colorimetry, of the surface of the pieces of uncoated quartz agglomerate and quartz agglomerate coated with thin transparent films of $TiO_2$ of different thicknesses according to the time of exposure to solar radiation.

Detailed Description of an Embodiment

1. Chemical activation of the surface with plasma (optional)

The base substrate is treated for 5 minutes with plasma, prior to the process of deposition, for the purpose of improving the subsequent adhesion of the layer to be deposited. This treatment chemically activates the surface with the generation of reactive groups (ions, radicals, atoms) which give rise to the creation of a very reactive hydrophilic surface which improves the subsequent adhesion of inorganic molecules.

2. Deposition of thin films of $TiO_2$ or ZnO.

According to the invention, the layers of $TiO_2$ or ZnO are deposited on the surface of the stone agglomerate. The process of dry deposition of thin films of $TiO_2$ or ZnO under a vacuum object of this invention comprises:

a) Plasma-enhanced chemical vapor deposition (PECVD)

The deposition of $TiO_2$ or ZnO by means of PECVD takes place after a chemical reaction between a plasma of a pure oxidative gas or a mixture of an oxidative gas and an inert gas and the vapor phase of any volatile precursor of titanium or zinc under vacuum conditions or at atmospheric pressure. The plasma of the oxidative gas, which is generated by supplying electromagnetic energy with a high frequency (microwaves, radio frequency or another frequency range used in plasma reactors, such as kHz-) or by a direct current, acts by breaking down the precursor, resulting in highly reactive species which react with one another, the products being deposited on the surface of the stone agglomerate in the form of a homogenous thin film of $TiO_2$ or ZnO, at a temperature close to ambient temperature.
The thin films of $TiO_2$, or of ZnO doped with cations of post-transition elements (Si or A1) or of transition elements, (Cr, V, W, Fe, Co) were deposited on the stone agglomerate by mixing the vapor of the volatile precursor of titanium or zinc with that of any volatile precursor of the doping agents, following the method described above. The composition of the doping agent is controlled by varying the flow rate of its corresponding precursor, the speed of the carrier gas through the precursor of Ti or Zn and/or by the temperature of the bubbling system of the precursor of Ti or Zn.
The resulting thin film, the thickness of which ranges between 0.005 - 10 $\mu$m, preferably between 150 nm - 2000 nm, according to the experimental conditions used, homogenously coats the entire surface of the agglomerate and is transparent.

b) Process of physical vapor deposition (PVD)

The physical vapor deposition (PVD) is a method of depositing thin films by means of a physical method under a vacuum, in which the solid starting material ($TiO_2$ or ZnO, referred to as the target) is evaporated by means of thermal heating or by bombardment with energetic ions or electrons (according to the method, there are processes based on electric arcs, ion beam, electron beam, cathode sputtering, etc.) accelerated with sufficient energy towards the target so as to break bonds and pull molecules off same. The evaporated material is deposited on the stone agglomerate without any chemical transformation of the starting material taking place in said process.
Likewise, the $TiO_2$ or ZnO has also been deposited through a process of Reactive PVD, consisting of the evaporation of atoms of Ti and Zn or sub-stoichiometric species of $TiO_x$ and $ZnO_x$ by any of the previous methods from targets of metallic Ti or Zn or of sub-oxides of these metals, which react with an oxidative gas or a mixture of oxidative and inert gas, generating the formation and the deposition of thin transparent films of $TiO_2$ or ZnO on the surface of the stone agglomerate.

By means of these techniques, thin films of $TiO_2$ or ZnO with a high adhesion to the base substrate and with a thickness comprised between 5 nm and 10 $\mu$m can be obtained, which films demonstrate a substantial improvement of the factor of protection after thicknesses greater than 10 nm, using to that end temperatures close to ambient temperature.

In the case of using a method of PVD, the surface activation by means of plasma is a recommendable process for assuring the adhesion of the layer.

3. Properties of the stone agglomerate coated with thin films of $TiO_2$ or ZnO

By means of all the described methods, the layer of $TiO_2$ or of ZnO undoped or doped with up to 20% of the described cations deposited on the stone agglomerates has high UV radiation absorption properties, as well as low photocatalytic activity, which allows very considerably increasing resistance to solar degradation.

In all the described cases, even when cations of post-transition elements were used as doping agents (Si or Al) the resulting layer is transparent and colorless so it preserves the original decorative aspect of the stone agglomerate. Nevertheless, when the stoichiometry of the deposited $TiO_2$ or ZnO varies from the nominal, or when it was doped with a proportion >10% of cations of the mentioned elements, the resulting transparent film has a certain color which, combined with the finish of some stone agglomerates, allows obtaining a more favorable aesthetic appearance.

In turn, these thin films have a strong adhesion to the surface of the agglomerate and high resistance to abrasion, so they can be applied in aggressive exterior environments. To this respect, it should be pointed out that an additional improvement of these last properties can be achieved when the surface of the stone agglomerate is activated with the plasma generated in the coating chamber and prior to the deposition of the $TiO_2$ or ZnO.

In addition, in all cases, the resulting surface has super-hydrophilic properties (contact angle with a drop of water close to 0°), when it is exposed to sunlight, which allows this material to also acquire super-hydrophilic or easy-to-clean properties.

Finally, the stone agglomerate coated with $TiO_2$ or ZnO doped with A1 cations additionally has antistatic properties since its surface resistivity decreases from $10^{13}$ $\Omega$ per square (insulator) to values which make the material insulator-dissipative ($10^4$-$10^9$ $\Omega$), which is highly desirable for its application in paving. Thus, the stone agglomerates coated with $TiO_2$ or ZnO present electrical resistivities of the order of $10^7$ $\Omega$ per square, whereas if the ZnO is doped with 3% A1 cations, the resistivity decreases to values of the order of $10^5$ $\Omega$.

The item object of this invention obtained by the PECVD technique therefore comprises:

Deposition on the stone agglomerate under vacuum conditions or at atmospheric pressure and at a temperature of less than 300°C of a thin film of $TiO_x$ (x being in the range 1.5 and 2.5) or $ZnO_y$ (y being in the range 0.6 and 1.4) with an amorphous or low crystallinity structure. It also comprises thin films of these crystalline or amorphous materials doped up to 20% with Al, Si, Cr, V, W, Fe, Co cations, with a thickness comprised between 5 nm and 10 $\mu$m, preferably between 150 nm - 2000 nm, and deposited in the same conditions.

Plasma generated from a pure oxidative gas or an oxidative gas diluted into an inert gas by supplying high frequency electromagnetic energy (microwaves, radio frequency or another frequency range used in plasma reactors,-kHz-), a direct current, or a pulsed direct current.

Any volatile precursor of titanium or zinc, such as titanium or zinc oxides, or their mixtures, as well as any of their suitable precursors, such as titanium tetraisopropoxide, titanium dimethyl diacetate, dimethylzinc, diethylzinc, zinc acetate, or their mixtures, for example, can also be used. If needed, a precursor of any of the elements used for doping A1, Si, Cr, V, Fe and Co, such as trimethylsilane trichloride, for example, can also be used.

Therefore, the item object of this invention obtained by the dry PVD technique comprises:

Thin film of $TiO_x$ (being x in the range 1.5 and 2.5) or $ZnO_y$ (being and in the range 0.6 and 1.4) which are amorphous or doped with A1, Si, Fe, Cr, V, Co cations of thickness comprised between 5 nm and 10 $\mu$m, preferably between 10 nm and 200 nm, more preferably between 35 nm and 200 nm, deposited on stone agglomerates under vacuum conditions and at a temperature of less than 300°c.

Evaporation of the target by means of thermal heating or by bombardment with electrons or ions accelerated with sufficient energy.

PVD carried out from a target of $TiO_2$ or ZnO formed by the oxide to be deposited.

Reactive PVD carried out from a solid metal target or a target formed by sub-oxides of these metals. The molecules pulled off the target react with a pure oxidative gas or an oxidative gas mixed with an inert carrier gas.

Deposition of a doped thin film from a target of the doping agent or from a target of $TiO_2$ or ZnO doped with the proportion of the cations which are to be incorporated.

The present invention is additionally illustrated by means of the following examples without intending to limit the scope of the invention.

EXAMPLES

<u>Example 1:</u> Coating with thin films of $TiO_2$ with amorphous structure and variable thickness of a slab of quartz agglomerate having dimensions of 300 x 150 cm and 20 mm thick by means of PECVD under a vacuum.

The process of deposition of a thin transparent film of $TiO_2$ on the surface of the quartz agglomerate, by means of the PECVD technique under a vacuum, was carried out by modifying the deposition time according to the desired thickness, under the following conditions:

- Plasma generated from a flow of 240 mL/min of an oxidative gas (pure $O_2$).
- Time of activation of the surface of the quartz agglomerate with plasma: 5 min.
- Power supplied for forming the plasma: 400 W at a frequency of 2.45 GHz.
- Operating pressure: 3 mtorr.
- Volatile precursor; of Ti(TV) tetraisopropoxide immersed in a thermostated storage chamber at 40°C.
- Flow of $O_2$ derivative for entraining the vapor of the volatile precursor to the plasma: 2.5 mL/min.
- Deposition rate: 0.9 $\mu$m/h.
- Temperature of the deposit: 45°C.

The overall chemical reaction taking place on the surface of the base substrate can be described as follows:

$$Ti(Oi\text{-}Pr)_4 + 6\ O_2 \leftrightarrow TiO_2 + 10\ H_2O + 8\ CO_2$$

occurring in different steps in the plasma, the complete mineralization of the ligands of the precursor of Ti not being necessary.

The resulting slabs were subjected to subsequent studies aimed at comparing their properties with ordinary slabs.

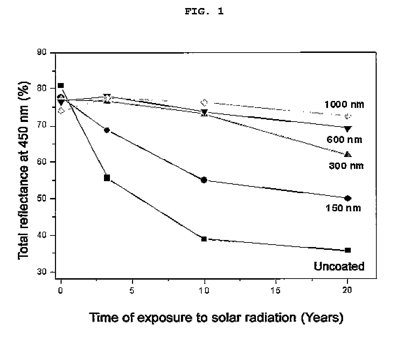

The evaluation of the resistance to UV degradation of the slabs was carried out by means of accelerated exposure to the sun of said slabs in a lamp which simulates the spectrum of natural solar radiation. The temporal degradation of a piece of white quartz agglomerate according to the deposited thickness of $TiO_2$ is shown next as an illustrative example. To that end, the reduction of the total reflectance values measured at 450 nm on the surface (Figure 1) was followed, the degradation being detected visually when a reduction of 5-6% of total reflectance occurs.

It was observed that while the uncoated sample has a rapid reduction of reflectance, the coated pieces show a clearly slower reduction, particularly those having thicker layers (greater than 300 nm). Thus, after their exposure to sunlight for an equivalent time of 15 years, the uncoated piece appears to be very degraded (completely yellow) and the coated pieces with thicknesses of 300 nm or greater remain intact. Therefore, the resistance to solar radiation of the coated agglomerates is much greater than the uncoated pieces, and the more so the greater the thickness of the thin film deposited.

These data allow us to easily calculate the factor of improvement of resistance to solar radiation of the quartz agglomerate over time according to the deposited thickness of $TiO_2$, according to the following formula:

$$t_e = f\ x\ t_0$$

where $t_e$ and $t_0$ are the times of resistance to solar degradation for a coated quartz agglomerate with a determined thickness of $TiO_2$ and an uncoated quartz agglomerate, respectively, determined from the time required for there to be a reduction of the reflectance by 5-6%, after which the degradation of the surface is observed visually, and f is the factor of temporal improvement achieved with said deposited thickness. The factors of improvement obtained according to the thickness are shown in Table 1.

Table 1.- Factor of temporal protection (f) against UV radiation achieved in the quartz agglomerate according to the deposited thickness of $TiO_2$:

| Thickness of $TiO_2$ (nm) | Factor of protection |
|---|---|
| 0 | 1 |
| 50 | 1 |
| 150 | 4 |
| 300 | 20 |
| 600 | 26 |

(continued)

| Thickness of $TiO_2$ (nm) | Factor of protection |
|---|---|
| 800 | 27 |
| 1000 | 28 |
| 2000 | 30 |

As can be observed, the resistance of the agglomerate increases with the deposited thickness according to a sinusoidal law. Thus, in order to achieve a very significant improvement in the resistance to UV degradation, it is necessary to deposit films of $TiO_2$ with thicknesses greater than 150 nm. Above this thickness, the degree of protection very considerably increases (with 300 nm a resistance 20 times greater is achieved) until reaching 600 nm (26 times greater), slightly improving above this value (28 and 30 times greater for layers of 1000 and 2000 nm respectively), the saturation thereof accordingly being reached.

Finally, when the surface of the quartz agglomerate is exposed to sunlight, it is observed that the contact angle of a drop of water with the surface thereof decreases from 80° to 0° when the surface is coated with $TiO_2$ regardless of the deposited thickness. These results indicate that the resulting surface is super-hydrophilic, whereby the resulting quartz agglomerate has super-hydrophilic and easy-to-clean properties, in addition to having a high resistance to solar degradation.

Example 2: Coating with thin transparent films of ZnO with amorphous structure with a thickness of 500 nm of a slab of quartz agglomerate with dimensions of 300 x 150 x 2 cm by means of PECVD.

The process of deposition was carried out under the following conditions:

- Plasma generated from a flow of 15 mL/min of an oxidative gas (purser).
- Time of activation of the surface of the quartz agglomerate with plasma: 5 min.
- Power supplied for forming the $O_2$ plasma: 200 W at a frequency of 2.45 GHz.
- Operating pressure: 1 Pa.
- Volatile precursor: diethylzinc ($Zn (Et)_2$).
- Flow of volatile precursor: 5 mL/min.
- Deposition rate: 1.0 $\mu$m/h.
- Temperature of the deposit: 25°C.

The resulting slabs were evaluated in a similar manner as in the case of Example 1. In this case, the resulting sample had a factor of improvement of 25 with regard to the resistance to solar radiation. The resulting surface in the presence of sunlight also has super-hydrophilic properties, so it can be applied as a self-cleaning surface in outdoor applications.

In addition to the properties of high resistance to solar radiation and super-hydrophilic or easy-to-clean properties, the resulting surface had clearly lower values of surface resistivity in relation to the uncoated surface. This clearly allows reducing the static charge accumulated in people when walking on the coated surfaces (< 0.5 kV, see Table 2), under the limit of human sensitivity (2-3 kV) and thus eliminating the possibility of receiving electric discharges upon contacting a metallic element.

Table 2.- Surface resistivity and static charge generated in people upon walking on a surface of uncoated quartz agglomerate or quartz agglomerate coated with a thin transparent film of 500 nm of ZnO.

| Type of stone agglomerate | Surface resistivity ($\Omega/\square$) | Static charge generated (kV) |
|---|---|---|
| Uncoated | $2.0 \times 10^{13}$ | 4 |
| Coated with ZnO | $2.4 \times 10^7$ | 0.3 |

Example 3: Coating with thin transparent films of $TiO_2$ with amorphous structure of variable thickness of a slab of quartz agglomerate with dimensions of 300 x 150 x 2 cm by means of reactive sputtering PVD.

The process of deposition was carried out under the following conditions:

- Target used: metallic Ti.
- Evaporation of the target by means of bombardment with Ar ions accelerated by applying a potential difference of 531 V and power of 6.57 kW/cm$^2$ at a frequency of 0.58 kHz.
- Operating pressure; 7 x 10$^{-3}$ torr.
- Flow of oxidative gas ($O_2$): 1.3 mL/min.
- Deposition rate: 1.0 $\mu$m/h.
- Deposit temperature: 70°C.

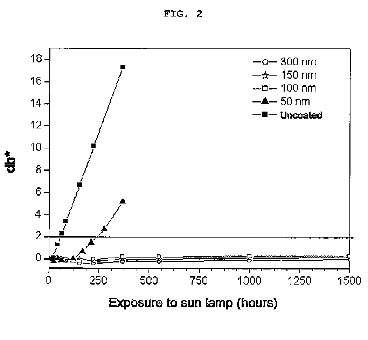

The resistance to solar radiation of the resulting slabs was evaluated in a similar manner as in the case of Example 1, in this case the degradation of the target surfaces of the quartz agglomerate being followed by means of the variation of the color parameter b* (yellowing) (Figure 2), the degradation being visually detected when an increase of db* of 2 units has taken place.

As can be observed, while the parameter b* of the uncoated sample has a rapid (linear) increase as a consequence of its yellowing, in the protected samples said parameter increases very slowly, particularly in the case of the samples having a thickness equal to or greater than 100 nm.

The factors of improvement of the resistance to solar radiation of the end surfaces according to the deposited thickness by means of this method when the parameter db* is 2 have been calculated in the same manner as in the case of Example 1. The obtained results are shown in Table 3.

Table 3.- Factor of temporal protection (f) against UV radiation achieved in the quartz agglomerate according to the deposited thickness of $TiO_2$:

| Thickness of $TiO_2$ (nm) | Factor of protection |
| --- | --- |
| 0 | 1 |
| 10 | 2 |
| 20 | 3 |
| 35 | 4.5 |
| 50 | 4.5 |
| 100 | > 30 |
| 150 | > 30 |
| 300 | > 30 |

As can be observed, the obtained results show a substantial improvement of the factor of protection in thicknesses greater than 10 nm, for being applied in items the durability of which is not a determining factor.

It can also additionally be observed how the resistance of the agglomerate increases very considerably (from a factor of 4.5 to > 30) when the deposited thickness of the film increases from 35 nm to 100 nm, having similar efficiency when greater thicknesses are used. This range of thicknesses can be applied in items durability of which is a determining factor.

Likewise, the resulting surface in the presence of sunlight also has super-hydrophilic properties, whereby the end product can also be applied as a self-cleaning surface in outdoor applications.

Example 4: Coating with thin transparent films of $TiO_2$ doped with 10% Si (IV) cations with a thickness of 400 nm of a slab of quartz agglomerate with dimensions of 300 x 150 x 2 cm by means of PECVD.

- Plasma generated from a flow of 240 mL/min of an oxidative gas ($O_2$ pure).
- Power supplied for forming the $O_2$ plasma: 400 W at a frequency of 2.45 GHz.
- Operating pressure: 6.5 x 10$^{-1}$ Pa.
- Volatile precursor of Ti: tetraisopropoxide of Ti(IV) immersed in a thermostated storage chamber a 40°C.
- Flow of $O_2$ derivative for entraining the vapor of the volatile precursor of Ti to the plasma of $O_2$: 2.5 mL/min.
- Volatile precursor of Si: trimethylsilane chloride (($CH_3$)$_3$SiCl).
- The Si/Ti ratio was controlled by means of changing the flow rate of the precursor of Si. For the deposit of a layer of $TiO_2$ doped with 10% Si, a flow of the volatile precursor of Si of 0.25 mL/min was used.
- Deposition rate: 0.9 $\mu$m/h.
- Deposit temperature: 45°C.

The resulting slabs were evaluated in a similar manner as in the case of Example 1. In this case, the resulting sample had a factor of improvement of 24 with respect to the resistance to solar radiation. The resulting surface in the presence of sunlight also has super-hydrophilic properties, so it can be applied as a self-cleaning surface in outdoor applications.

**Claims**

1.  An item made from agglomerated stone coated on at least one portion of its faces with a thin transparent film, with low or nil photocatalytic activity, comprising $TiO_2$ and/or ZnO, deposited by dry deposition techniques.

2.  The item according to claim 1, **characterized in that** the $TiO_2$ or ZnO mainly has an amorphous structure.

3.  The item according to claim 1, **characterized in that** the $TiO_2$ or ZnO are doped with up to 20% cations of transition elements, preferably Cr, V, W, Fe, Co, or post-transition elements such as Al or Si.

4.  The item according to claims 1-3, **characterized in that** the item made from agglomerated stone consists of a granite/quartz and polyester resin agglomerate.

5.  The item according to claims 1-3, **characterized in that** the item made from agglomerated stone consists of a marble and polyester resin agglomerate.

6.  The item according to claims 1-5, **characterized in that** the volatile precursor of titanium or zinc can be titanium or zinc oxides, or their mixtures, as well as any of their suitable precursors, such as for example, titanium tetraisopropoxide, titanium dimethyl diacetate, dimethylzinc, diethylzinc, zinc acetate, or their mixtures.

7.  The item according to claims 1-6, **characterized in that** the deposited films have a thickness between 5 nm and 10 $\mu$m.

8.  The item according to claims 1-7, **characterized in that** the deposited films have a thickness between 150 nm and 2000 nm.

9.  The item according to claims 1-8, **characterized in that** the deposited films have a thickness between 10 nm and 200 nm.

10. The item according to claims 1-9, **characterized in that** the deposited films have a thickness between 35 nm and 200 nm.

11. The item according to claims 1-10, **characterized in that** it has a factor of protection against solar UV radiation between 4 and 30 times greater than the same item without the deposited layer or with a thickness less than that indicated, equivalent up to 20 years of exposure to the sun.

12. The item according to claims 1 to 11, **characterized in that** it has a resistivity between $10^4$-$10^9$ $\Omega$.

13. The item according to claims 1 to 12, **characterized in that** it has a resistivity of $10^7$ $\Omega$.

14. A process for obtaining an item made from agglomerated stone according to claims 1-13, **characterized in that** the thin film deposited on at least one portion of its faces without photocatalytic activity comprising $TiO_2$ or ZnO, mainly in amorphous phase, is deposited by dry deposition techniques, specifically by physical vapor deposition (PVD) or plasma-enhanced chemical vapor deposition (PECVD).

15. The process for obtaining an item made from agglomerated stone according to claim 14, **characterized in that** the plasma-enhanced chemical vapor deposition (PECVD) process can be performed under a vacuum or at atmospheric pressure.

16. The process for obtaining an item made from agglomerated stone according to claims 14-15, **characterized in that** an additional optional step of surface activation by means of plasma is performed prior to the step of PVD or PECVD deposition.

17. Use of an item made from agglomerated stone according to claims 1-13, obtained according to the process according to claims 13-16, **characterized in that** it is used in outdoor environments, such as façades, outdoor floors and stairways, for example.

FIG. 1

FIG. 2

# INTERNATIONAL SEARCH REPORT

| International application No. |
| --- |
| PCT/ ES 2009/000393 |

| A. CLASSIFICATION OF SUBJECT MATTER |
| --- |
| see extra sheet |
| According to International Patent Classification (IPC) or to both national classification and IPC |

| B. FIELDS SEARCHED |
| --- |
| Minimum documentation searched (classification system followed by classification symbols)<br>C04B,C23C |
| Documentation searched other than minimum documentation to the extent that such documents are included in the fields searched |
| Electronic data base consulted during the international search (name of data base and, where practicable, search terms used)<br><br>INVENES,EPODOC |

C. DOCUMENTS CONSIDERED TO BE RELEVANT

| Category* | Citation of document, with indication, where appropriate, of the relevant passages | Relevant to claim No. |
| --- | --- | --- |
| A | WO 0100541 A1 (ITAL-CEMENTI SPA) 04.01.2001,<br>page 3, lines 18-28 | 1-17 |
| A | US 2002006481 A (MORRIS) 17.01.2002,<br>claims 1 and 14 | 1-17 |
| A | EP 1780006 A2 (PLANOLITH GMBH) 02.05.2007,<br>claims 1 and 18 | 1-17 |
| A | BASE DE DATOS WPI EN EPOQUE, AN 2006-607870,<br>JP2006239490 (DENRYOKU), 14.09.2006, abstract | 1-17 |
| A | BASE DE DATOS WPI EN EPOQUE, AN 2003-049353,<br>JP2002234107 (NAGASE), 20.08.2002, abstract | 1-17 |

☐ Further documents are listed in the continuation of Box C.      ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance.<br>"E" earlier document but published on or after the international filing date | |
| "L" document which may throw doubts on priority claim(s) or which is cited to establish the publication date of another citation or other special reason (as specified)<br>"O" document referring to an oral disclosure use, exhibition, or other means<br>"P" document published prior to the international filing date but later than the priority date claimed | "X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other documents , such combination being obvious to a person skilled in the art |
| | "&" document member of the same patent family |

| Date of the actual completion of the international search<br>23.November.2009          (23.11.2009) | Date of mailing of the international search report<br>(25.11.2009) |
| --- | --- |
| Name and mailing address of the ISA/<br>O.E.P.M.<br><br>Paseo de la Castellana, 75 28071 Madrid, España.<br>Facsimile No.   34 91 3495304 | Authorized officer<br>J. García-Cernuda Gallardo<br><br>Telephone No. +34 91 349 53 52 |

Form PCT/ISA/210 (second sheet) (July 2008)

## INTERNATIONAL SEARCH REPORT

Information on patent family members

| | International application No. |
|---|---|
| | PCT/ ES 2009/000393 |

| Patent document cited in the search report | Publication date | Patent family member(s) | Publication date |
|---|---|---|---|
| WO 0100541 A | 04.01.2001 | ITMI 991422 | 27.12.2000 |
| | | IT 1312119 B | 04.04.2002 |
| | | EP 1196359 AB | 17.04.2002 |
| | | US 6824826 B | 30.11.2004 |
| | | AT 389623 T | 15.04.2008 |
| | | PT 1196359 E | 30.06.2008 |
| | | EP 1944279 A | 16.07.2008 |
| | | DK 1196359 T | 21.07.2008 |
| | | ES 2303510 T | 16.08.2008 |
| | | DE 60038379 T | 09.04.2009 |
| | | | 09.04.2009 |
| US 2002006481 A | 17.01.2002 | NONE | ------------ |
| EP 1780006 A | 02.05.2007 | EP 20060022003 | 20.10.2006 |
| | | DE 102005051557 A | 03.05.2007 |
| JP 2006239490 A | 14.09.2006 | NONE | ------------ |
| JP 2002234107 A | 20.08.2002 | NONE | ------------ |

Form PCT/ISA/210 (patent family annex) (July 2008)

**INTERNATIONAL SEARCH REPORT**

| International application No. |
| --- |
| PCT/ ES 2009/000393 |

CLASSIFICATION OF SUBJECT MATTER

*C04B 41/50* (2006.01)
*C04B 41/51* (2006.01)
*C23C 16/40* (2006.01)

Form PCT/ISA/210 (extra sheeet) (July 2008)

**EP 2 325 152 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2006100321 A1
- WO 9710185 A1
- WO 9944954 A1
- EP 1837319 A2
- WO 2008045226 A1